# EUROPÄISCHE PATENTANMELDUNG

(11) **EP 4 611 196 A2**
(43) Veröffentlichungstag der Anmeldung: **03.09.2025**
(21) Anmeldenummer: 25160810.5
(22) Anmeldetag: 28.02.2025
(51) Int. Cl.: H02H 3/20, H02H 3/04, H02H 3/05, G01R 31/327, H02J 9/06, H02H 3/46, H02H 3/50

(54) **AUTOMATISCHE NETZUMSCHALTEINRICHTUNG UND VERFAHREN ZUR AUTOMATISCHEN NETZUMSCHALTUNG**

(30) Priorität: 02.03.2024 DE 102024106097
(71) Anmelder: ESA Elektroschaltanlagen Grimma GmbH, 04668 Grimma (DE)
(72) Erfinder: Mehnert, Manuel, 04808 Wurzen (DE)
(74) Vertreter: Völger, Karl Wolfgang

(57) **Zusammenfassung**

Die vorliegende Erfindung bezieht sich auf eine automatische Netzumschalteinrichtung umfassend
- zumindest zwei elektrotechnisch schaltbare Schaltglieder,
- eine Spannungs-Überwachungseinrichtung für die zumindest zwei elektrotechnisch schaltbaren Schaltglieder,
- eine integrierte Steuerspannungs-Umschaltung,
- zumindest eine Ansteuerung für die elektrotechnisch schaltbaren Schaltglieder,
- zumindest eine Steuerkreisüberwachung,
- eine Einrichtung zur Plausibilitätsprüfung des erfolgten Umschaltens einschließlich Bewerten des Antriebes, der Hilfselemente und der Spannungsbeurteilung am Ausgang.

Die vorliegende Erfindung bezieht sich ferner auf ein Verfahren zur automatischen Netzumschaltung.

## Beschreibung

Die vorliegende Erfindung betrifft eine automatische Netzumschalteinrichtung und ein Verfahren zur automatischen Netzumschaltung.

Netzumschalteinrichtungen sind aus dem Stand der Technik grundsätzlich bekannt und werden in Anwendungen eingesetzt, in denen zwei Quelleneinspeisungen verwendet werden. Sie überwachen permanent die Spannungen der Versorgungs- und Abgangsleitungen und führen selbstständig eine Umschaltung auf die alternative Stromversorgung durch, wenn die bevorzugte Quelleneinspeisung außerhalb der definierten Betriebsparameter (Spannung und Frequenz) arbeitet. Es handelt sich dabei fast ausschließlich um Stromversorgungsnetze mit Wechselspannung. Die eigentliche Umschaltung erfolgt über zwei Schaltglieder, die entsprechend angesteuert werden.

So beschreibt DE 10 2005 054 806 B3 ein Verfahren und eine Vorrichtung zur Prüfung der Steuerkreise einer Spannungsumschaltung für ein ungeerdetes isoliertes Wechselspannungsnetz. In diesem Stand der Technik werden die Steuerstromkreise einer Spannungsumschaltung, die bei Ausfall eines Hauptstromnetzes auf ein Notstromnetz über Leistungsschütze umschaltet und bei der ein nachgeordnetes isoliertes Wechselspannungsnetz und eine Isolationsüberwachung angeordnet ist, mit Hilfe von Spannungs- und Stromauswertungen in den Steuerstromkreisen überwacht und geprüft. Ferner soll die geräteinterne Schaltfunktion der Spannungsumschaltung unter Vermeidung von Umschalttests nachgewiesen werden, indem die Stromversorgung des isolierten Wechselspannungsnetzes überwacht wird.

Die bekannten Netzumschalteinrichtungen weisen Nachteile dahingehend auf, dass nicht überprüfbar ist ob, die Umschaltung tatsächlich erfolgt ist und ob diese auch erfolgreich durchgeführt wurde. Es besteht daher der Bedarf an einer neuartigen automatischen Netzumschalteinrichtung und einem entsprechend neuartigen Verfahren zur automatischen Netzumschaltung.

Der vorliegen Erfindung liegt daher die Aufgabe zugrunde, eine automatische Netzumschalteinrichtung bereitzustellen und ein Verfahren zur automatischen Netzumschaltung anzugeben, welche die Nachteile des Standes der Technik überwinden und eine technische Lösung schaffen, um unter anderem eine vorgenommene Netzumschaltung überprüfbar zu machen.

Diese Aufgabe wird in einem ersten Aspekt der vorliegenden Erfindung durch eine automatische Netzumschalteinrichtung gelöst, umfassend
- zumindest zwei elektrotechnisch schaltbare Schaltglieder,
- eine Spannungs-Überwachungseinrichtung für die zumindest zwei elektrotechnisch schaltbaren Schaltglieder,
- eine integrierte Steuerspannungs-Umschaltung,
- zumindest eine Ansteuerung für die elektrotechnisch schaltbaren Schaltglieder,
- zumindest eine Steuerkreisüberwachung,
- eine Einrichtung zur Plausibilitätsprüfung des erfolgten Umschaltens einschließlich Bewerten des Antriebes, der Hilfselemente und der Spannungsbeurteilung am Ausgang.

Mit "elektrotechnisch schaltbaren Schaltglieder" werden im Sinne der vorliegenden Erfindung Leistungsschalter oder Lasttrennschalter oder Schütze oder gleichwertige Schaltelemente bezeichnet. Die elektrotechnisch schaltbaren Schaltglieder können auch als ein kombiniertes Schaltglied mit zwei oder mehr darin vorgesehenen elektrotechnisch schaltbaren Schaltgliedern ausgeführt sein.

Die erfindungsgemäße automatische Netzumschalteinrichtung bietet die technische Voraussetzung, um die Überwachung aller anliegenden Spannungen vor und hinter den elektrotechnisch schaltbaren Schaltgliedern sicherzustellen. Dabei kann auch die Überwachung des Schaltzustandes auf EIN / AUS und ausgelöst vorgenommen werden, wenn diese Meldung abrufbar ist. Erfolgt eine Schalthandlung, wird geprüft ob, auf der/den abgehenden Versorgungsleitung/en nach dem Umschalten die Spannung auf der abgehenden Leistung vorhanden ist. Gleichzeitig wird über einen Hilfskontakt die Änderung der Schalter (EIN / AUS) über die erfindungsgemäße automatische Netzumschalteinrichtung eingelesen und mit den Spannungswerten bzw. Änderungen auf Plausibilität geprüft.

Zusätzlich kann z.B. über die Messung der Spannungen vor und hinter dem Schaltglied der Schaltkontaktzustand der einzelnen Schaltglieder bewertet werden. Zusätzlich kann durch die Historiendokumentation dieser Daten ein entsprechender Alterungsprozess dokumentiert und später eine Wartung/Instandhaltung prognostiziert werden.

Über eine Messung und Auswertung der Übergangswiederstände der Schaltkontakte kann eine Beurteilung über die Abnutzung erfolgen. (neues Merkmal, bisher nicht Umgesetzt) Damit ist eine vorbeugende Wartung / Reparatur des Schaltelementes möglich.

In einer bevorzugten Ausführungsform der Erfindung umfasst die automatische Netzumschalteinrichtung ferner ein Notaus-Modul, welches über einen digitalen Kontakt oder ein digitales Signal verbunden über ein BUS-System in elektrischer Wirkverbindung mit allen elektrotechnisch schaltbaren Schaltglieder steht.

Das "Notaus-Modul" ist dazu ausgelegt, über den digitalen Kontakt oder ein digitales Signal verbunden über ein BUS-System alle elektrotechnisch schaltbaren Schaltglieder auszuschalten, wenn eine Signaländerung eintritt. Die "elektrische Wirkverbindung" besteht daher in einer elektrischen Schaltfunktion.

Das erfindungsgemäße Notaus-Modul dient in vorteilhafter Weise der sicheren Abschaltung der nachgeordneten Verbraucher, insbesondere im Hinblick auf die Verwendung von Solarenergie oder Windenergie zur Sicherstellung von Überlastschutz und/oder Brandschutz.

Es hat sich für die effektive und effiziente Überwachung einer Netzumschaltung als vorteilhaft herausgestellt, wenn in der erfindungsgemäßen automatischen Netzumschalteinrichtung die integrierte Steuerspannungs-Umschaltung eine Prüfeinrichtung für ein kurzzeitüberlappendes Rückschalten von einer sekundären Spannungsquelle auf eine primäre Spannungsquelle auf Synchronität der Spannungsquellen bezüglich Spannungshöhe, Frequenz und Phasenwinkel aufweist.

Die "Prüfeinrichtung" ist dazu ausgelegt, bei einem kurzzeitüberlappenden Rückschalten von der sekundären Spannungsquelle auf die primäre Spannungsquelle vor dem Rückschalten die Spannungsquellen auf Synchronität bezüglich Spannungshöhe, Frequenz und Phasenwinkel in vorgegeben Toleranzen zu prüfen.

Dies hat den Vorteil, dass die überlappende Schaltung erst erfolgt, wenn alle Werte innerhalb der vorgegeben Toleranzen liegen. Für einen kurzen definierten Zustand sind dabei beide elektrotechnisch schaltbaren Schaltglieder eingeschaltet.

In einer Weiterbildung der erfindungsgemäßen automatischen Netzumschalteinrichtung umfasst diese ferner einen Web-Server.

Der erfindungsgemäß vorgesehene Web-Server ermöglich in vorteilhafter Weise das Auslesen von Messwerten, Zuständen, Meldespeichern, Parametrierungsdaten, Update der geräteinternen Firmware vorzugsweise per CAN-Schnittstelle und/oder Web-Schnittstelle. Weitere Vorteile und Möglichkeiten werden nachstehend ausgeführt.

Besonders bevorzugt wird eine Ethernet-Schnittstelle bereitgestellt (RJ45 Buchse, 10 bit/s, galvanische Trennung).

Eine bevorzugte Ausführungsform der erfindungsgemäßen automatischen Netzumschalteinrichtung sieht vor, dass
- die Spannungs-Überwachungseinrichtung Signalwandler, Mikroprozessoren, Speicher, Analog-Digital-Wandler und zumindest eine Analogbaugruppe aufweist,
   und / oder
- die Steuerspannungs-Umschaltung eine integrierte Umschalteinrichtung aufweist, welche Signalwandler, Analog-Digital-Wandler, zumindest eine Analogbaugruppe und mindestens ein Sicherheitsrelais umfasst
   und / oder
- die Ansteuerung für die Schaltglieder Messmodule, Prozessoren, Speicherbausteine und Logikoperatoren aufweist.

Diese oben genannten Baugruppen sind in Hard- und Software als Module entwickelt worden. Damit wird ein Austausch / Erweiterung, Verfügbarkeit von Komponenten vereinfacht. Des Weiteren lassen sich damit weitere neue Geräte-Ressourcen schonend und schnell ableiten.

In einer besonderen Ausführungsform der erfindungsgemäßen automatischen Netzumschalteinrichtung weist diese Abmessungen von 160 mm x 90 mm x 75 mm bzw. maximal 9 Teilungseinheiten auf.

Nach dem Stand der Technik sind die Geräte für das Generieren der Steuerspannung und die Spannungsüberwachung mit Umschalteinrichtung zwei separate Geräte. Diese separaten Geräte sind mit Kabeln miteinander verbunden. Das herkömmliche Gerät zur Spannungsüberwachung mit Umschalteinrichtung hat einen Platzbedarf von l x b x h von 75 mm x 160 mm x 90 mm, das Gerät zum Generieren der Steuerspannung von l x b x h von 73 mm x 106 mm x 90 mm. Nachteilig ist hier der Platzbedarf der zwei Geräte, die Verdrahtung der Geräte untereinander, wobei bei einem Kabelbruch oder einem falschen Anklemmen nach einer Reparatur bei einem von den beiden Geräten die Funktion der gesamten Umschalteinrichtung beeinträchtigt ist, sowie ein erhöhter Wartungsaufwand, da die Verkabelung auf mechanische und chemische Einwirkungen wie Alterung / Abnutzung regelmäßig geprüft werden muss.

Demgegenüber stellt die vorliegende Erfindung mit der erfindungsgemäßen automatischen Netzumschalteinrichtung ein einziges Gerät zur Verfügung, das mit den angegebenen Maßen etwa die Hälfte des Platzbedarfs hat.

Die vorstehend genannte Aufgabe wird in einem zweiten Aspekt der vorliegenden Erfindung durch ein Verfahren zur automatischen Netzumschaltung gelöst, umfassend die Schritte
a) Überwachen von ein- und mehrphasigen Netzen mit mehreren Kanälen auf Überspannung und Unterspannung, Abweichung von der Netzfrequenz, Abweichen von der Spannungsqualität, Umschaltzeiten und Rückmeldekontakte von elektrotechnisch schaltbaren Schaltgliedern,
b) Bereitstellen einer Steuerspannung zur Ansteuerung von elektrotechnisch schaltbaren Schaltgliedern für Schaltkontaktansteuerungen durch eine in einer Steuerspannungs-Umschaltung integrierten Umschalteinrichtung oder Überwachen zumindest einer extern zur Verfügung gestellten Steuerspannungsversorgung,
c) selbständiges Schalten von elektrotechnisch schaltbaren Schaltgliedern mittels einer integrierten Umschaltsteuerung bei Vorliegen von Überspannung oder Unterspannung oder Abweichung von der Netzfrequenz oder Abweichung von der Spannungsqualität von Spannungswerten an angelegten primären Spannungsquellen auf eine vorhandene und innerhalb eingestellter Grenzen verfügbare sekundäre Spannungsquelle,
d) Überwachen des durchgeführten Schaltens mit Plausibilitätsprüfung durch Überwachen aller anliegenden Spannungen vor und hinter den elektrotechnisch schaltbaren Schaltgliedern, wobei geprüft wird, ob auf der zumindest einen abgehenden Versorgungsleitung nach dem Schalten die Spannung vorhanden ist, und gleichzeitig über einen Hilfskontakt die Änderung der elektrotechnisch schaltbaren Schaltgliedern (EIN / AUS) eingelesen und mit den Spannungswerten / Änderungen auf Plausibilität geprüft wird.

Als "Spannungsqualität" werden im Sinne der vorliegenden Erfindung die Komponenten Spannung (Spannungshöhe, Frequenz, Kurvenform), Flicker, Oberschwingungen, Transienten und Schieflast verstanden.

Aus dem Stand der Technik ist die Überwachung von zwei unterschiedlichen Spannungsquellen bekannt. Diese Spannungsquellen können 1-phasig, 3-phasig, 230 V, 400 V AC 50/60Hz und unterschiedliche Netzformen (IT-, TT-, TN-, TN-S-, TN-C- und TN-C-S-Netz) haben. Die Schalter können mit zusätzlichen Positionskontakten erweitert werden. Bekannt aus dem Stand der Technik ist auch, dass bei einem Ausfall der priorisierten / bevorzugten Spannungsquelle, auf die alternative Spannungsquelle geschaltet wird. Die Netzform der Spannungsquellen (Quelle 1 zu Quelle 2) können gleich oder unterschiedlich sein.

Nachteilig an dieser bekannten Steuerung ist jedoch, dass nicht überprüft wird ob,
- die Umschaltung erfolgt ist durch eine Prüfung und Auswertung der Änderung der Hilfskontakte,
- die Umschaltung erfolgt ist durch eine Messung und Auswertung der gemeinsamen Leitung nachgelagert hinter den Schaltern,
- eine Prüfung vorgenommen wurde, ob eine Umschaltung erfolgreich durchgeführt wurden ist, d.h. eine logische Prüfung von den Änderungen (Rückmelde / Hilfskontakte der Schalter) in Bezug auf die Spannung der gemeinsamen Leitung 3 erfolgt nach dem Stand der Technik nicht.

Demgegenüber bietet das erfindungsgemäße Verfahren die Überwachung der durchgeführten Umschaltung mit Plausibilitätsprüfung. Erfindungsgemäße wird eine Überwachung aller anliegenden Spannungen vor und hinter den Schaltern vorgenommen. Die Überwachung des Schaltzustandes auf EIN / AUS und ausgelöst erfolgt, wenn diese Meldung abrufbar ist. Erfolgt eine Schalthandlung, wird geprüft, ob auf der/den abgehenden Versorgungsleitung/en nach dem Umschalten die Spannung auf der abgehenden Leitung vorhanden ist. Gleichzeitig wird über einen Hilfskontakt die Änderung der Schalter (EIN / AUS) über das Gerät eingelesen und mit den Spannungswerten / Änderungen auf Plausibilität geprüft.

Stand der Technik ist ferner, dass die Steuerspannung für die Schalter extern bereitgestellt wird. Die geschieht meist aus einer batteriegestützten oder alternativen Spannungsquelle (Netzersatzaggregat, Brennstoffzelle). Nachteilig an dieser Lösung ist jedoch, dass
- die Verfügbarkeit der Anlage durch lange Leitungswege, mechanische Einwirkung auf die Kabel beeinträchtigt ist,
- die Steuerspannung nicht im abgeschlossenen Verteiler erzeugt, sondern extern angeschlossen wird,
- meist nur eine Quelle für die Steuerspannung vorhanden ist was bedeutet, dass bei Ausfall dieser einen Quelle gleichzeitig mehrerer automatische Umschalteinrichtungen nicht mehr funktional sind,
- die batteriegestützten oder alternativen Spannungsquellen regelmäßig gewartet werden müssen, wobei die automatische Umschalteinrichtung dann nicht funktionstüchtig ist,
- eine Überwachung der Steuerspannung nicht erfolgt.

Demgegenüber wird erfindungsgemäß die zum Schalten der elektrotechnisch schaltbaren Schaltglieder benötigte Steuerspannung in der erfindungsgemäßen automatischen Netzumschalteinrichtung selbst generiert. Das Bilden der sicheren Steuerspannung erfolgt durch eine integrierte Umschalteinrichtung in der erfindungsgemäßen automatischen Netzumschalteinrichtung. Im normalen Betriebszustand wird die Steuerspannung von der alternativen Quelle bezogen.

In einer erfindungsgemäßen Weiterbildung des Verfahrens umfasst dieses ferner eine aktive Überwachung der Steuerspannungsanschlüsse der elektrotechnisch schaltbaren Schaltglieder auf Drahtbruch (Durchgängigkeit) und Funktionalität durch eine Überlagerung der Steuerspannung mit einer geringen Spannung als Dauerimpuls oder Signalimpuls und ständiger Auswertung, wobei die aktive Überwachung der Steuerspannungsanschlüsse ferner zusätzlich die Messung des Isolationswiderstandes der Steuerspannungsanschlüsse beinhalten kann.

Aus dem Stand der Technik ist bekannt, dass die Steuerspannung durch einfache Lösungen (z.B. Spannungsschleife) überwacht wird. Dabei wird eine Kleinspannung auf den Strompfad der Steuerkreise (Einschalt- / Ausschaltkontakte) überlagert. Es wird geprüft, ob die Spannung an dem Steuergerät zurückgeführt wird. Nachteilig an dieser Lösung ist jedoch, dass
- es keine Überwachung bei Isolationsschäden gibt, so dass eine vorbeugende Diagnose / Warnung nicht möglich ist, ein Ausfall bei einer langsamen Beschädigung der Isolation (mechanisch / chemisch / Fremdsubstanzen) nicht detektierbar ist,
- eine Alterung der Einschalt- / Ausschaltkontakte und die Korrosion der Meldekontakte (Veränderung des Übergangswiederstandes) nicht detektierbar ist.

Demgegenüber bietet das erfindungsgemäße Verfahren eine aktive Überwachung der Streuspannung. Die von der erfindungsgemäßen automatischen Netzumschalteinrichtung erzeugte Steuerspannung wird in den relevanten Strompfaden aktiv auf Drahtbruch und Funktionalität überwacht. Dabei wird der komplette Strompfad von dem Gerät über die komplette Verdrahtung, inklusive Hilfskontakte und Einschalt- / Ausschaltauslöser bezüglich Durchgängigkeit überwacht. Die Überwachung wird durch eine Überlagerung der Steuerspannung mit einer geringen Spannung als Dauerimpuls oder Signalimpuls (Rechteck, Dreieck, Sinus) und ständiger Auswertung realisiert. Dafür ist bei Schaltgliedern, die eine aktive Steuerspannung benötigen, ein zusätzliches Gerät notwendig (AÜW). Bei Schaltgliedern, die eine Steuerspannung selbst erzeugen (Kleinspannung 5 V - 50 V AC / DC), erfolgt die Überlagerung wie vorstehend beschrieben, jedoch mit einer kleineren Spannung. Ein unabsichtliches Schalten der Schaltglieder muss verhindert werden. Die aktive Steuerspannungsüberwachung ist im Bereich von 5 V - 50 V AC / DC und 0 V bis 230 V AC möglich. Um alle Schaltertypen bezüglich Überwachung abdecken zu können und Fehlauslösungen der Schalter zu verhindern, müssen die Signalimpulse und die Spannungsebenen frei parametrierbar sein.

Eine weitere Überwachung zur Sicherstellung der sicheren Ansteuerung der Schaltglieder wird erfindungsgemäß durch die dauerhafte Messung und Bewertung des Isolationswiderstandes der Anschlussleitungen vorgenommen. Diese Überwachung ist notwendig, um im Falle eines Umschaltens eine Abschaltung der Stromversorgung der Steuerspannung durch einen Fehler der Isolation zu verhindern. Die aktive Überwachung der Steuerspannung kann auch für die Messung des Isolationswiderstandes verwendet werden.

In einer Ausführungsform umfasst das erfindungsgemäße Verfahren ferner eine Notaus-Funktion, bei welcher über einen digitalen Kontakt bei Signaländerung alle elektrotechnisch schaltbaren Schaltglieder ausgeschaltet werden.

Stand der Technik ist, dass die Steuerung von Umschalteinrichtungen nur in den Betriebsarten Automatikbetrieb oder Handbetrieb arbeitet, wobei der Automatikbetrieb die bevorzugte Betriebsart ist. Der Handbetrieb wird an der Steuerung vor Ort aktiviert (Passworteingabe, Schlüsselschalter oder ähnliche Sicherungsmaßnahme gegen Fehlbedienung). In diesem Modus können die Schalter über die Umschalteinrichtung gesteuert werden. Nachteilig an dieser Lösung ist, dass
- die Betriebsart nur vor Ort an der Anlage gewechselt werden kann,
- die Sicherungsmaßnahme (Passworteingabe, Schlüsselschalter oder ähnliches) nur einem begrenzten Personenkreis bekannt ist, was in einem Notfall zu gefährlichen Verzögerung führen kann,
- ein Ausschalten aller Spannungsquellen nur von dem elektrotechnisch unterwiesen Personal und nicht durch elektrotechnische Laien durchgeführt werden kann.

Demgegenüber sieht die vorliegende Erfindung die Funktion NOTAUS / ECO Modus vor. Über einen digitalen Kontakt oder ein digitales Signal verbunden über ein BUS-System können, bei Signaländerung, alle beiden elektrotechnisch schaltbaren Schaltglieder ausgeschaltet werden. Diese Betriebsart ist zur sicheren Abschaltung der nachgeordneten Verbraucher gedacht. Wichtige Stichpunkte sind hier die Energiewende, Solarenergie, Windenergie, Überlastschutz, Brandschutz.

Dies Funktion kann auch z.B. von Rettungskräften wie Feuerwehr oder THW genutzt werden, um im spannungslosen Zustand gefahrfrei Rettungen durchführen zu können. Zudem kann diese Betriebsart auch zur aktiven Energieeinsparung genutzt werden, um Prozesse komplett spannungsfrei zu schalten.

Das erfindungsgemäße Verfahren kann in einer Weiterbildung ferner die Betriebsarten Automatikbetrieb, Handbetrieb und Fernbetrieb umfassen, wobei zwischen den Betriebsarten gewechselt werden kann.

Wie vorstehend schon erwähnt, ist aus dem Stand der Technik die Steuerung der Umschalteinrichtungen nur in den Betriebsarten Automatikbetrieb oder Handbetrieb bekannt. Eine Änderung der Betriebsart ist nur vor Ort möglich. Nachteilig an dieser Lösung ist, dass
- bei einer gewünschten Änderung diese immer vor Ort vorgenommen werden muss, wobei Zugänglichkeit und Wegzeiten zu den Umschalteinrichtungen zu Verzögerungen führen,
- eine Betriebsart Fernbetrieb, um die Umschalteinrichtung von der Ferne zu steuern, nicht vorgesehen ist.

Demgegenüber sieht das erfindungsgemäße Verfahren drei Betriebsarten für das Umschalten vor. Die erfindungsgemäße automatische Umschalteinrichtung unterstützt diese drei Betriebsarten Automatikbetrieb, Handbetrieb und Fernbetrieb. Zwischen den Betriebsarten kann über das Menü an der automatischen Umschalteinrichtung oder über die Eingänge der automatischen Umschalteinrichtung gewechselt werden. Die Betriebsart Automatikbetrieb ist für den Betrieb als ATSE vorgesehen. Die Betriebsart Fernbetrieb ist für die Steuerung der Umschalteinrichtung in besonderen Betriebszustand (Havarie, Feuerwehrabschaltung, Brand, Wartung von extern) vorgesehen. Die Betriebsart Handbetrieb ist für die Steuerung vor Ort vorgesehen.

Eine spezielle Ausführungsform des erfindungsgemäßen Verfahrens umfasst ferner ein kurzzeitüberlappendes Rückschalten von der sekundären Spannungsquelle auf die primäre Spannungsquelle, wobei vor dem Rückschalten die Spannungsquellen auf Synchronität bezüglich Spannungshöhe, Frequenz und Phasenwinkel in vorgegeben Toleranzen geprüft werden.

Aus dem Stand der Technik ist bekannt, dass die Umschaltungen von einer Spannungsquelle auf die andere Spannungsquelle mit einer Unterbrechung der gemeinsamen Leitung erfolgt. Nachteilig an dieser Lösung ist, dass
- es immer zu Unterbrechungen bei den Verbrauchern kommt, die hinter der gemeinsamen Leitung angeschlossen sind,
- die regelmäßigen Wartungen und Funktionstests der Umschalteinrichtung immer zur Unterbrechungen bei den Verbrauchern führen.

Demgegenüber ist mit der vorliegenden Erfindung ein kurzzeitüberlappendes Schalten möglich, bei dem geprüft wird, ob beide Spannungsquellen hinsichtlich Spannungshöhe, Frequenz und Phasenwinkel synchronisiert sind. Wenn alle Werte innerhalb der vorgegeben Toleranzen liegen, erfolgt eine überlappende Schaltung. Für einen kurzen definierten Zustand sind dabei beide elektrotechnisch schaltbaren Schaltglieder eingeschaltet.

Schließlich umfasst das erfindungsgemäße Verfahren in einer weiteren Ausführungsform eine vorbeugende Wartungsdiagnose über die gesamte Lebensdauer der automatischen Netzumschalteinrichtung, wobei Umschaltzeiten der Schalter, Schaltspiele, durchgeführte Funktions- und Wartungen, die Abnutzung der Schaltkontakte und die Temperatur der automatischen Netzumschalteinrichtung an mehreren Messstellen protokolliert werden.

Stand der Technik ist, dass die Umschaltzeiten der Schalter, die Schaltspiele der Schalter, durchgeführte Funktionstests und Wartungen sowie die Temperatur des Gerätes nicht ausgewertet wird. Nachteilig an dieser Lösung ist, dass
- ein Verschleiß der Schalter, Verschleiß der Schaltkontakte, überhöhte Temperaturen, durchgeführte Funktionstests und Wartungen nicht ausgewertet werden,
- eine Vorbeugende Wartung / Reparatur oder eine Reparaturplanung nicht möglich ist.

Demgegenüber stellt die vorliegende Erfindung eine vorbeugende Wartungsdiagnose bereit, bei der über die gesamte Lebensdauer der automatischen Netzumschalteinrichtung Umschaltzeiten der Schalter, Schaltspiele, Abnutzung der Schaltkontakte, durchgeführte Funktionstests und Wartungen sowie die Temperatur der automatischen Netzumschalteinrichtung an mehreren Messstellen (Prozessor und Innenraum des Gerätes) protokolliert werden. Bei einer Abweichung der eingestellten Parameter wird der Nutzer über mehrere Level (Erinnerung, Warnung / Voralarm, Alarm) informiert.

Das erfindungsgemäß Verfahren kann ferner nach einer speziellen Ausführungsform ferner ein Messverfahren zur Auswertung des Kontaktverschleißes der elektrotechnisch schaltbare Schaltglieder umfassen. Über die Messleitungen der Spannungsquellen und der gemeinsamen abgehenden Leitung kann durch eine Signalmodulation mit anschließender Auswertung de Ohm'sche Wiederstand über die Kontakte der elektrotechnisch schaltbaren Schaltglieder ermittelt werden. Bei jedem Schaltvorgang gibt es einen Kontaktabbrand, was sich in einem schlechter werden Ohm'schen Widerstand kontinuierlich nachweisen lässt. Eine qualitative Auswertung der Schaltkontakte ist damit möglich.

Weitere Ziele, Merkmale, Vorteile und Anwendungsmöglichkeiten ergeben sich aus der nachfolgenden Beschreibung von der Erfindung nicht einschränkenden Ausführungsbeispielen, auch anhand der Figuren. Dabei bilden alle beschriebenen und/oder bildlich dargestellten Merkmale für sich oder in beliebiger Kombination den Gegenstand der Erfindung, auch unabhängig von ihrer Zusammenfassung in den Ansprüchen oder deren Rückbeziehung. Es zeigen:
- Fig. 1: eine schematische Darstellung einer typischen zwei- bis vierpolig ausgelegten Umschalteinrichtung nach einer Ausführungsform der Erfindung,
- Fig. 2: eine schematische Darstellung einer zweipoligen Umschaltung mit einem kombinierten Kompaktschaltglied nach einer anderen Ausführungsform der Erfindung
- Fig. 3: eine schematische Darstellung einer drei-, vierpoligen Umschaltung mit einem kombinierten Kompaktschaltglied nach einer weiteren Ausführungsform der Erfindung,
- Fig. 4: eine schematische Darstellung einer drei-, vierpoligen Umschaltung mit zwei getrennten elektrotechnisch schaltbaren Schaltgliedern nach einer anderen Ausführungsform der Erfindung und
- Fig. 5: eine schematische Darstellung einer zweipoligen Umschaltung mit zwei getrennten elektrotechnisch schaltbaren Schaltgliedern nach einer anderen Ausführungsform der Erfindung.

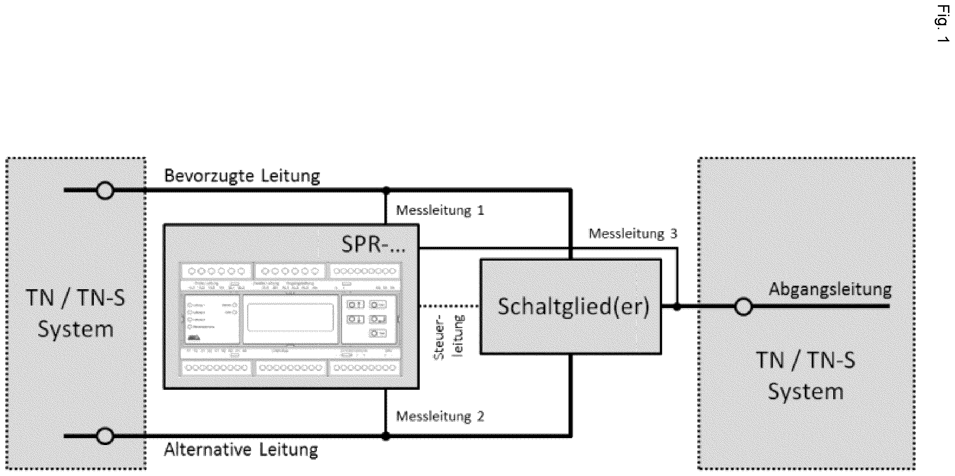

In Figur 1 wird eine typische zwei- bis vierpolig ausgelegten Umschalteinrichtung nach einer Ausführungsform der Erfindung schematisch dargestellt. Dieser Darstellung ist zu entnehmen, dass die Steuerung mit zwei separaten Steuerspannungen versorgt wird und dass es eine Überwachung der Abgangsleitung in Form eine Spanungsmessung gibt.

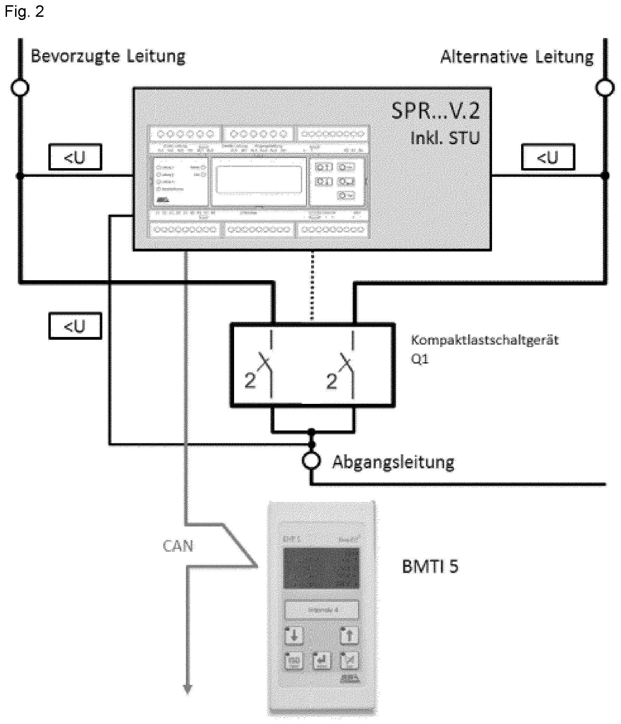

Figur 2 zeigt schematisch eine andere Ausführungsform der Erfindung einer zweipoligen Umschaltung mit einem kombinierten Kompaktschaltglied sowie mit einem optional anschließbaren Überwachungsterminal BMTI5. Alternativ können selbstverständlich auch zwei getrennte Schaltglieder eingesetzt werden.

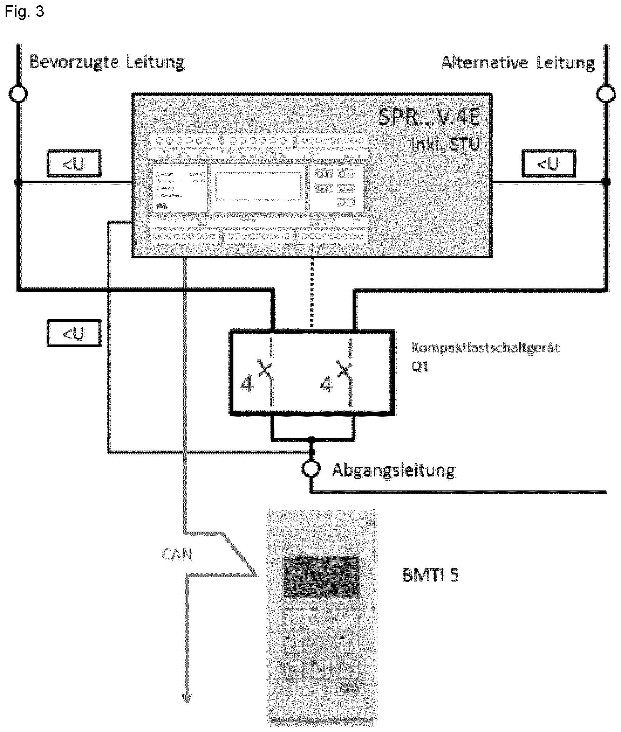

In Figur 3 wird eine weitere Ausführungsform der Erfindung einer drei-, vierpoligen Umschaltung mit einem kombinierten Kompaktschaltglied sowie mit einem optional anschließbaren Überwachungsterminal BMTI5 schematisch dargestellt. Alternativ können selbstverständlich auch zwei getrennte Schaltglieder eingesetzt werden.

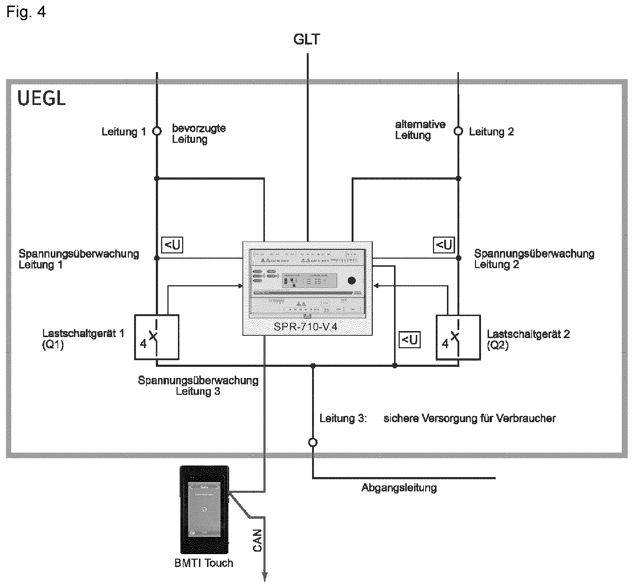

Fig. 4 zeigt grundsätzlich die in Figur 3 dargestellte Konfiguration, nur dass hier zwei getrennte elektrotechnisch schaltbare Schaltglieder anstelle eines kombinierten Kompaktschaltglieds vorgesehen sind.

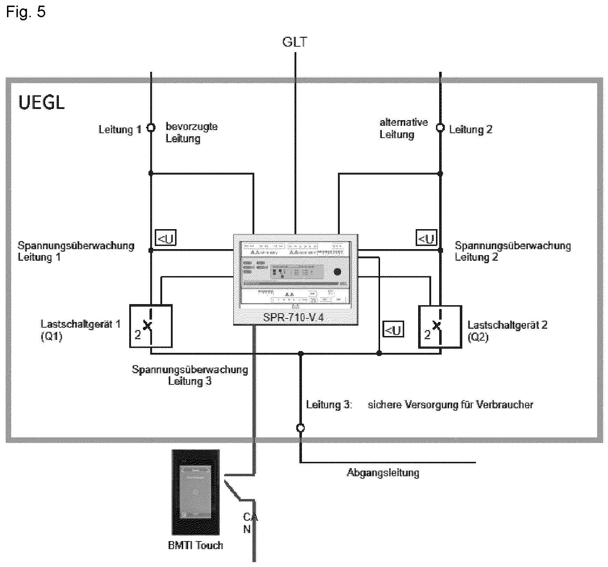

Ebenso zeigt Fig. 5 grundsätzlich die in Figur 2 dargestellte Konfiguration, nur dass hier zwei getrennte elektrotechnisch schaltbare Schaltglieder anstelle eines kombinierten Kompaktschaltglieds vorgesehen sind.

Bei Umschalteinrichtungen in medizinisch genutzten Räumen der Stufe AG2 werden entsprechend der DIN / VDE 0100 Teil 710 besondere Anforderungen an die Stromversorgung und Überwachung gestellt. Diese Anforderungen sollen die Verfügbarkeit der Stromversorgung im Patientenbereich erhöhen. Unter dieser Maßgabe sind alle elektrotechnischen Systeme Ein-Fehler-Sicher auszulegen.

Ein erster Fehler darf nicht zum Ausfall der Stromversorgung führen. Durch geeignete Maßnahmen ist die Stromversorgung zu gewährleisten. Für die sichere Stromversorgung werden automatische Umschalteinrichtungen eingesetzt. Die Stromversorgung erfolgt über zweie unabhängige Versorgungsleitungen. Nur eine dieser Versorgungsleitungen ist aktiv. Die zweite Leitung wird vorgehalten und bei Bedarf zugeschalten. Für die Steuerung sind Messwerte permanent auszuwerten.

Die Erfindung beschreibt ein Verfahren, um aus elektrotechnisch schaltbaren Schaltgliedern eine sichere automatische Netzumschalteinrichtung mit Überwachung entsprechend der NORM DIN VDE 0100 Teil 710 zu ermöglichen. Bei den elektrotechnisch schaltbaren Schaltgliedern werden solche mit mehreren schaltbaren Polen genutzt (Bsp. 2-/3-4-polig).

Durch diese Flexibilität ist es möglich, entsprechende Systeme schalterunabhängig einzusetzen. Ebenfalls ist die Reparatur und Ersatzteilbeschaffung einfacher möglich. Durch die Integration einer Web-basierten Schnittstelle ist eine Fernanalyse, Änderung der Konfiguration und Update der Firmware der erfindungsgemäßen automatischen Netzumschalteinrichtung über das Intranet / Internet mittels Internetbrowser ohne zusätzliche Software möglich.

Die zu verwendenden elektrotechnisch schaltbaren Schaltglieder besitzen vorzugsweise folgende technischen Spezifikationen. Die Schaltstellung wird über einen internen oder externen potenzialfreien Kontakt bereitgestellt. Die elektrotechnisch schaltbaren Schaltglieder haben eine Handbedienebene, um sie manuell zu schalten. Erfolgt eine manuelle Bedienung, wird ein potenzialfreier Hilfskontakt, intern oder extern, geschaltet. Die Ansteuerung der elektrotechnisch schaltbaren Schaltglieder erfolgt extern über potenzialbehaftete oder potenzialfreie Kontakte.

Die Erfindung stellt die Steuerspannung für die elektrotechnisch schaltbaren Schaltglieder bereit. Die Steuerspannung wird auf mögliche Unterbrechungen überwacht. Die Steuerung der Schalter und die Steuerungsart (Dauerkontakt / Impuls) wird über die Erfindung durch die parametrierbaren Ansteuerungsmodi der elektrotechnisch schaltbaren Schaltglieder realisiert. Verschiedene Verzögerungszeiten können eingestellt werden. Beispielsweise eine Hinschaltverzögerung, eine Rückschaltverzögerung und eine Wartezeit zwischen bzw. während des Umschaltvorganges. Für die Umschaltzeiten können Warnlevels hinterlegt werden. Dauert die Umschaltung länger als das eingestellte Warnlevel erfolgt eine Meldung. Diese kann für vorbeugende Wartungsmaßnahmen genutzt werden. Die elektrotechnisch schaltbaren Schaltglieder sind elektrisch gegeneinander verriegelt. Damit ist es nicht möglich, beide elektrotechnisch schaltbaren Schaltglieder ungewollt zeitgleich einzuschalten.

Im gewollten praktischen Fall handelt es sich um überlappendes Rückschalten, d.h. beide Versorgungsleitungen müssen wieder ordnungsgemäß vorhanden sein. Dabei werden Spannung, Frequenz und Phasenlage gemessen bzw. verglichen und erst wenn beide Netze (Versorgungsleitungen) annähernd gleich sind, kann überlappend rückgeschaltet werden.

Das überlappende Umschalten ist insbesondere eine Sonderfunktion in der Software und diese kann mit einem Passwort geschützt sein. Bedingung ist der Ausfall von Leitung 1 mit Umschaltung auf Leitung 2, was eine Unterbrechung bedingt. Bei Spannungswiederkehr von Leitung 1 sind beide Leitungen wieder vorhanden. Das überlappende Rückschalten auf Leitung 1 erfolgt dann ohne Unterbrechung

Ferner kann eine periodische Testumschaltung (z.B. 1x jährlich) vorgenommen werden. Hier wird tatsächlich gewollt überlappend hin- und wieder rückgeschaltet. Das passiert bei einem jährlichen Wartungstermin. Damit während der Wartung im Krankenhaus die Verbraucher nicht spannungslos geschalten werden, wird die Testumschaltung überlappend ausgeführt. Bedingung ist, dass beide Versorgungsleitungen ordnungsgemäß anliegen.

Die Erfindung hat vorzugsweise einen integrierten Web-Server. Die Kommunikation erfolgt mittels Ethernet-Anschluss. Der Web-Server stellt eine Web-Seite zur Verfügung. Auf dieser Web-Seite werden alle aktuellen Messsignale, der Zustand der Anlage, der Historienspeicher und der Status der erfindungsgemäßen automatischen Umschalteinrichtung angezeigt. Die Schaltspiele und das Einbaudatum der elektrotechnisch schaltbaren Schaltglieder werden in der Historie gespeichert. Die Anlagenparameter können über die Web-Seite geändert werden. Die Authentifizierung erfolgt über ein zwei Schlüsselverfahren. Ein Schlüssel wird über den Web-Server an das Gerät übertragen. Den zweiten Schlüssel gibt der Nutzer vor Ort ein. Erst danach können die Parameter geändert werden.

Die Erfindung stellt eine Auswahl von elektrotechnisch schaltbaren Schaltgliedern zur Verfügung. Mittels einfacher Auswahl des Herstellers und des Schaltertyps werden die entsprechenden Steuerungszeiten und die Steuerungsart bereitgestellt. Wird ein elektrotechnisch schaltbares Schaltglied eines nicht in der Liste befindlichen Typs genutzt, kann der Nutzer die Steuerungszeiten und Steuerungsart nach Herstellerangabe selbständig einstellen.

Für Wartungen, zum vorübergehenden Stromsparen oder für SicherheitsAnforderungen, zum Beispiel im Brandfall, wird ein einstellbarer Kontakt oder ein digitales Signal verbunden über ein BUS-System als Eingang zur Verfügung gestellt. Dieser Kontakt kann beide elektrotechnisch schaltbaren Schaltglieder ausstellen.

Die Messung der Spannungen erfolgt mit einer Genauigkeit von 1 % oder besser über den gesamten Temperaturbereich. Die Spannungsmessung erfolgt in einem Frequenzbereich bis zu mehreren Kilohertz. Die Messung der Differenzspannungen zwischen allen Phasen der bevorzugten und der alternativen Leitung erfolgt permanent. Sind die Spannungen der bevorzugten und der alternativen Leitungen synchron und die Differenzspannungen der Phasen zueinander innerhalb des eingestellten Wertes, kann eine überlappende Umschaltung (Rückschaltung) ohne Unterbrechung der Abgangsleitung erfolgen. Diese Option ist in der Umschaltsteuereinrichtung vorgesehen.

Die Erfindung besitzt eine einstellbare Rückschaltsperre. Ist die Anlage im Betriebsmodus Alternativnetz EIN, bevorzugtes Netz AUS, und das bevorzugte Netz ist wieder innerhalb der eingestellten Parameter, erfolgt keine automatische Rückschaltung auf das Alternativnetz. Die Rückschaltung gibt der Nutzer manuell frei. Danach erfolgt eine automatische Umschaltung auf das bevorzugte Netz.

Die vorliegende Erfindung weist die nachstehend stichpunktartig aufgeführten weiteren Merkmale auf.

### Webserver

- Webpage
- Darstellung der Website erfolgt nach Corporate Design Richtlinien und obliegt der Kreativität der Entwicklungsabteilung
- Erstellung einer Website mit folgenden Funktionen
   o Darstellung des verwendeten Geräts als Grafik
   o Anzeige des momentanen Gerätezustandes, Messwerte
   o Parametrierung der Einstellwerte (keine Parameter mit Servicepasswortzugang), Übernahme erfolgt erst bei Bestätigung am Gerät vor Ort
   o Firmware Update, Ausführung erfolgt erst bei Bestätigung am Gerät vor Ort
   o Anzeige der Meldespeicher Konfigurationsverlauf, Fehlerhistorie, Funktionstesthistorie als Teil der "vorgeschriebenen periodischen Funktionsprüfung"
   o Anzeige der Wartungstermine
   o Export der Meldespeicher und Wartungstermine
   o Export von zusätzlichen Fehlercodes zur genaueren Fehlerdiagnose als die Fehlermeldungen im Display
   o Emailversand bei Störungen, periodischer Funktionsprüfungen, anstehender Wartungen
   o bis zu 3 Emailadressen einstellbar
   o Unterscheidung Servicepersonal, User
- Login per Passwort
   o Echtzeitmesswerte, Aktualisierung aller 1s
- Export der Meldespeicher im csv-Format
- Firmwareupdate Webserver / SPR / UEI
- nur HTTPS-Kommunikation
- alle Nullspannungssicheren Geräteparameter können parametriert werden
- Bedienungsanleitung als PDF zum Herunterladen

### Feuerwehr bzw. ECO Funktion

- schaltet bei Betätigung die Schaltglieder in die Neutralstellung bzw. Nullstellung
- Funktion wird über DI (z. Bsp. Schlüsselschalter) oder ein digitales Signal verbunden über ein BUS-System angetriggert
- Funktion kann im Menü (de-)aktiviert werden, indem man einen DI dafür zuordnet oder nicht

Vorbeugende Wartungsdiagnose, die zur frühzeitigen Erkennung von Verschleiß, Durchführung der Wartungstermine und Fehlfunktionen dient
- Protokollierung der Schaltzeiten, Schaltspiele, Abnutzung der Schalterkontakte, Wartungstermine, Schaltglied 1 / 2 ausgetauscht am ...
- letzte 2 Schaltgliedtauschzeitpunkte anzeigen
- Tauschzeitpunkt ist Rückstellzeitpunkt des Schaltspielzählers
- Information des Nutzers über bevorstehende Termine (Parametrierbar)
- Emailversand für anstehende Wartungstermine/ -maßnahmen

### Quelleneinspeisungsumschaltung

- Umschaltung auf eine alternative Versorgungsleitung bei Ausfall der bevorzugten Versorgungsleitung
- Parametrierbare bevorzugte Leitung (Leitung 1 oder Leitung 2), userpasswortgeschützt
- überlappende Umschaltung mit Prüfung, ob alternative Versorgungsleitung synchron und spannungsgleich ist (Verriegelung müsste hier außer Kraft gesetzt sein)
- Einstellung überlappende Umschaltung mit Servicepasswort geschützt
- Betriebsmodi: Automatikbetrieb, Handbetrieb und Fernbetrieb
- Elektrische Verriegelung der Lastschalter zusätzlich zur Softwareverriegelung zur zweistufigen Verhinderung, dass beide Versorgungsleitungen gleichzeitig zugeschaltet sind, Ausnahme: Überlappende Schaltung Möglichkeit einer Umschaltung in unter 0,5 s zur entsprechenden Einstufung Klasse 0,5 nach Norm DIN VDE 0100-560 (VDE 0100-560):2011-03, 560.4
- Umschaltung mit und ohne Priorität:
   o mit: sobald die bevorzugte Leitung zurückkehrt, wird zurückgeschaltet
   o ohne: erst wenn die alternative Leitung ausfällt, wird zurückgeschaltet
- Sicherstellung der Ansteuerung der Motorlastschalter bei Ausfall einer beliebigen Stromversorgungsleitung (STU-Funktion)
- Hinschaltverzögerung parametrierbar
- Rückschaltverzögerung parametrierbar
- Nullhaltezeit parametrierbar
- Menüpunkte im Display mindestens per Userpasswort geschützt
- Wenn alle Zeiten auf 0 gestellt sind, soll eine Umschaltung in weniger als 0,5 s erfolgen können (Erfüllung der Anforderungen für Umschaltung Klasse 0,5)
- Verhinderung einer ständigen Hin- und Herschaltung, z. B. aufgrund Messwertrauschens, Spannungseinbrüchen,
- Einbinden von Pausenzeiten nach 3 Umschaltversuchen
- aktive Drahtbruchüberwachung, wenn möglich integriert
- durchschnittliche Schaltzeiten, letzten 10 Umschaltungen im Menü abrufbar

## Patentansprüche

1. Automatische Netzumschalteinrichtung umfassend
- zumindest zwei elektrotechnisch schaltbare Schaltglieder,
- eine Spannungs-Überwachungseinrichtung für die zumindest zwei elektrotechnisch schaltbaren Schaltglieder,
- eine integrierte Steuerspannungs-Umschaltung,
- zumindest eine Ansteuerung für die elektrotechnisch schaltbaren Schaltglieder,
- zumindest eine Steuerkreisüberwachung,
- eine Einrichtung zur Plausibilitätsprüfung des erfolgten Umschaltens einschließlich Bewerten des Antriebes, der Hilfselemente und der Spannungsbeurteilung am Ausgang.

2. Automatische Netzumschalteinrichtung nach Anspruch 1, ferner umfassend ein Notaus-Modul, welches über einen digitalen Kontakt oder ein digitales Signal verbunden über ein BUS-System in elektrischer Wirkverbindung mit allen elektrotechnisch schaltbaren Schaltglieder steht.

3. Automatische Netzumschalteinrichtung nach Anspruch 1 oder 2, wobei die integrierte Steuerspannungs-Umschaltung eine Prüfeinrichtung für ein kurzzeitüberlappendes Rückschalten von einer sekundären Spannungsquelle auf eine primäre Spannungsquelle auf Synchronität der Spannungsquellen bezüglich Spannungshöhe, Frequenz und Phasenwinkel aufweist.

4. Automatische Netzumschalteinrichtung nach einem der Ansprüche 1 bis 3, ferner umfassend einen Web-Server.

5. Automatische Netzumschalteinrichtung nach einem der Ansprüche 1 bis 4, wobei
- die Spannungs-Überwachungseinrichtung Signalwandler, Mikroprozessoren, Speicher, Analog-Digital-Wandler und zumindest eine Analogbaugruppe aufweist,
und / oder
- die Steuerspannungs-Umschaltung eine integrierte Umschalteinrichtung aufweist, welche Signalwandler, Analog-Digital-Wandler, zumindest eine Analogbaugruppe und mindestens ein Sicherheitsrelais umfasst und / oder
- die Ansteuerung für die Schaltglieder Messmodule, Prozessoren, Speicherbausteine und Logikoperatoren aufweist.

6. Automatische Netzumschalteinrichtung nach einem der Ansprüche 1 bis 5, wobei diese Abmessungen von 160 mm x 90 mm x 75 mm bzw. maximal 9 Teilungseinheiten aufweist.

7. Verfahren zur automatischen Netzumschaltung, umfassend die Schritte
a) Überwachen von ein- und mehrphasigen Netzen mit mehreren Kanälen auf Überspannung und Unterspannung, Abweichung von der Netzfrequenz, Abweichen von der Spannungsqualität, Umschaltzeiten und Rückmeldekontakte von elektrotechnisch schaltbaren Schaltgliedern,
b) Bereitstellen einer Steuerspannung zur Ansteuerung von elektrotechnisch schaltbaren Schaltgliedern für Schaltkontaktansteuerungen durch eine in einer Steuerspannungs-Umschaltung integrierten Umschalteinrichtung oder Überwachen zumindest einer extern zur Verfügung gestellten Steuerspannungsversorgung,
c) selbständiges Schalten von elektrotechnisch schaltbaren Schaltgliedern mittels einer integrierten Umschaltsteuerung bei Vorliegen von Überspannung oder Unterspannung oder Abweichung von der Netzfrequenz oder Abweichung von der Spannungsqualität von Spannungswerten an angelegten primären Spannungsquellen auf eine vorhandene und innerhalb eingestellter Grenzen verfügbare sekundäre Spannungsquelle,
d) Überwachen des durchgeführten Schaltens mit Plausibilitätsprüfung durch Überwachen aller anliegenden Spannungen vor und hinter den elektrotechnisch schaltbaren Schaltgliedern, wobei geprüft wird, ob auf der zumindest einen abgehenden Versorgungsleitung nach dem Schalten die Spannung vorhanden ist, und gleichzeitig über einen Hilfskontakt die Änderung der elektrotechnisch schaltbaren Schaltgliedern (EIN / AUS) eingelesen und mit den Spannungswerten / Änderungen auf Plausibilität geprüft wird.

8. Verfahren nach Anspruch 7, ferner umfassend eine aktive Überwachung der Steuerspannungsanschlüsse der elektrotechnisch schaltbaren Schaltglieder auf Drahtbruch (Durchgängigkeit) und Funktionalität durch eine Überlagerung der Steuerspannung mit einer geringen Spannung als Dauerimpuls oder Signalimpuls und ständiger Auswertung, wobei die aktive Überwachung der Steuerspannungsanschlüsse ferner zusätzlich die Messung des Isolationswiderstandes der Steuerspannungsanschlüsse beinhalten kann.

9. Verfahren nach Anspruch 7 oder 8, ferner umfassend eine Notaus-Funktion, bei welcher über einen digitalen Kontakt oder ein digitales Signal verbunden über ein BUS-System bei Signaländerung alle elektrotechnisch schaltbaren Schaltglieder ausgeschaltet werden.

10. Verfahren nach einem der Ansprüche 7 bis 9, ferner umfassend die Betriebsarten Automatikbetrieb, Handbetrieb und Fernbetrieb, wobei zwischen den Betriebsarten im laufenden Betrieb gewechselt werden kann.

11. Verfahren nach einem der Ansprüche 7 bis 10, ferner umfassend ein kurzzeitüberlappendes Rückschalten von der sekundären Spannungsquelle auf die primäre Spannungsquelle, wobei vor dem Rückschalten die Spannungsquellen auf Synchronität bezüglich Spannungshöhe, Frequenz und Phasenwinkel in vorgegeben Toleranzen geprüft werden.

12. Verfahren nach einem der Ansprüche 7 bis 11, ferner umfassend eine vorbeugende Wartungsdiagnose über die gesamte Lebensdauer der automatischen Netzumschalteinrichtung, wobei Umschaltzeiten der Schalter, Schaltspiele, durchgeführte Funktions- und Wartungen und die Temperatur der automatischen Netzumschalteinrichtung an mehreren Messstellen protokolliert werden.
